## Europäisches Patentamt

**European Patent Office**

**Office européen des brevets**

(11) Publication number: **0 206 603**
**B1**

## (12) EUROPEAN PATENT SPECIFICATION

(45) Date of publication of patent specification: **23.01.91**

(21) Application number: **86304347.7**

(22) Date of filing: **06.06.86**

(51) Int. Cl.[5]: **C 23 C 16/48,** C 30 B 25/10,
C 30 B 23/06, C 30 B 29/04

(54) Method for growing crystals.

(30) Priority: **07.06.85 ZA 854340**

(43) Date of publication of application:
**30.12.86 Bulletin 86/52**

(45) Publication of the grant of the patent:
**23.01.91 Bulletin 91/04**

(84) Designated Contracting States:
**BE DE GB NL**

(56) References cited:
**EP-A-0 127 499**
**DE-A-3 303 084**

**JAPANESE JOURNAL OF APPLIED PHYSICS.
SUPPLEMENTS 16th INTERNATIONAL
CONFERENCE SOLID-STATE DEVICES AND
MATERIALS, 30th August - 1st September 1984,
pages 1-4, Tokyo, JP; J. NISHIZAWA et al.:
"Recent progress in low temperature
photochemical processes"**

(73) Proprietor: **MORRISON PUMPS S.A. (PTY) LTD.**
**45 Main Street**
**Johannesburg Transvaal (ZA)**

(72) Inventor: **Sellschop, Jacques P.F.**
**60 Greenhill Road Greenhill Extension**
**Johannesburg Transvaal (ZA)**

(74) Representative: **Ellis-Jones, Patrick George
Armine et al**
**J.A. KEMP & CO. 14 South Square Gray's Inn**
**London WC1R 5EU (GB)**

## Description

This invention relates to crystal growth and more particularly to diamond growth.

Various methods are known for synthesising diamond in its thermodynamically metastable region. These methods include diamond synthesis from the gas phase in microwave plasma and chemical vapour deposition of diamond in RF glow discharge as well as physical deposition methods such as sputtering and ion beam deposition. A review of these various methods can be found in the paper by D. V. Fedoseev et al which appears in the publication Russian Chemical Reviews, 53 (5), 1984 at pages 435 to 444.

Another method of producing diamond growth on a crystal substrate is described in the complete specification of South African Patent No. 82/1177. This method includes the steps of depositing a layer of a suitable amorphous or partially crystalline material on the surface of the substrate and subjecting the coated surface to irradiation by a suitable laser beam.

According to the present invention, there is provided a method of producing diamond crystal growth on a substrate including the steps of depositing carbon ions or atoms on or in the surface of a substrate and simultaneously irradiating the deposited carbon by a laser beam having a wavelength so chosen as to obtain resonance absorption by excitation of characteristic lattice vibrations in the deposited carbon. The irradiating laser beam will generally be caused to scan the surface as the deposition is occurring.

Essential to the invention is that the ions or atoms are irradiated by a laser beam as they are deposited on or in the surface of the substrate. This may be achieved, for example, by focussing the beam on the area of the substrate being subjected to the deposition.

The ions or atoms may be deposited on or in the substrate surface by any technique known in the art such as physical vapour deposition, chemical vapour deposition, sputtering, cracking, ion implantation and plasma induced chemical vapour deposition.

The laser beam may be a continuous wave or pulsed laser suitable for the resonance absorption. Such beams have been described in the literature. For example, tunable radiation in the 5 μm wavelength region may be used.

Factors which should be observed in carrying out the method of the invention are:

I. Resonance absorption can be maximised by

(a) tuning or sweeping the laser over optimum wave lengths, or

(b) using a linearly polarised photon beam oriented in relation to the substrate crystal axes.

II. The energy density in the crystal growth region can be controlled by

(a) laser intensity,

(b) laser pulse duration and time structure,

(c) scanning of a continuous wave laser beam over the surface, or

(d) adjustment of substrate thermal conductivity through a factor of about 10 by temperature control.

Activation energy can be supplied to the atoms in the deposited layer. This activation energy can be supplied by

(a) electronic excitation of atoms by UV photons of suitably tuned wave length, or

(b) deposition of ions, atoms or molecules having a high free energy. For example, in the case of carbon, the condensation and subsequent cracking of acetylene on a substrate surface of diamond achieves this.

Suitable impurities or dopants may be introduced into the deposited layer in controlled amounts to promote crystal growth. This can be achieved, for examples, by providing C=N radicals. The presence of nitrogen, both in the substrate (e.g. type Ia diamond) as well as in the deposited layer, also allows for the possibility of resonant energy transfer in the 7.8 μm wavelength region.

Growth of large area thin crystal films may be facilitated by an initial depth-profiled deposition of a suitable impurity into the substrate surface. Implantation of a small concentration of nitrogen into the substrate surface (which would not substantially alter lattice parameters and would thus not interfere with subsequent crystal growth on this surface) would provide localised resonance absorption of photons of 7.8 μm wavelength. Cleavage over a large area may then be induced by an intense pulse of 7.8 μm radiation, releasing the thin layer of epitaxially grown diamond.

The substrate on which the crystal growth occurs may be crystalline or non-crystalline. The substrate is preferably crystalline. Examples of suitable crystal substrates are germanium, silicon, gallium arsenide, indium antimonide, and molybdenum. A particularly suitable example of the crystalline substrate is diamond.

Independent or simultaneous illumination of the deposited material by other radiations including particle beams and discharges may be used to enhance growth.

Examples of particularly suitable methods of deposition are:

1. Plasma induced chemical vapour deposition. In this method it may be advantageous to enhance dissociation of the molecular hydrogen into atomic hydrogen and this may be achieved using a laser beam which may be the same or different to that used to induce the resonance absorption in the deposited material. The same laser beam can be used to activate the chemical decomposition of the carbon source material (normally a hydrocarbon such as methane).

2. Carbon can be sublimed from a suitable solid carbon source, e.g. graphite. The sublimation may be achieved using a laser beam.

3. High energy carbon ions can be implanted in the surface of a diamond and the laser beam focussed on the implanted ions below the surface of the substrate.

The diamond growth on the substrate may be epitaxial, polycrystalline or single crystal. The nature of the growth will depend on factors such as the nature of the substrate, the temperature of the substrate and the carbon flux rate and the chemical activity of the carbon atoms deposited on or in the surface.

It is also possible by the method of the invention to introduce dopant atoms such as boron into the diamond crysal grown on the substrate. By the method of the invention it is possible to enhance the tendency for the dopant atom to find its way more readily into a substitutional position than other doping methods known in the art. This is particularly advantageous as dopant atoms are electrically active only when in lattice positions.

## Claims

1. A method of producing diamond crystal growth on a substrate which comprises depositing carbon ions or atoms on or in the surface of a substrate and simultaneously irradiating the deposited carbon by a laser beam having a wavelength so chosen as to obtain resonance absorption by excitation of characteristic lattice vibrations in the deposited carbon.

2. A method according to claim 1 wherein the laser beam is a continuous wave or pulsed laser suitable for resonance absorption.

3. A method according to claim 1 or claim 2 wherein the carbon ions or atoms are deposited on or in the substrate surface by physical vapour deposition, chemical vapour deposition, sputtering, cracking, ion implantation or plasma-induced chemical vapour deposition.

4. A method according to any one of claims 1 to 3 wherein the substrate is a crystalline substrate.

5. A method according to claim 4 wherein the crystalline substrate is germanium, silicon, gallium arsenide, indium antimonide or molybdenum.

6. A method according to claim 4 wherein the crystalline substrate is diamond.

7. A method according to claim 6 wherein the crystal growth of the diamond is epitaxial, polycrystalline or single crystal.

8. A method according to any one of the preceding claims wherein a dopant atom is introduced into the grown diamond crystalline material.

## Patentansprüche

1. Verfahren zur Züchtung von Diamant-Kristallen auf einem Substrat, umfassend die Abscheidung von Kohlenstoff-Ionen oder -Atomen auf oder in der Oberfläche eines Substrats und die gleichzeitige Bestrahlung des abgeschiedenen Kohlenstoffs mit einem Laser-Strahl mit einer Wellenlänge, die so gewählt ist, daß eine Resonanz-Absorption durch Anregung charakteristischer Gitter-Schwingungen in dem abgeschiedenen Kohlenstoff erhalten wird.

2. Verfahren nach Anspruch 1, worin der Laser-Strahl ein für eine Resonanz-Absorption geeigneter Dauerstrich-Laser oder ein Impuls-Laser ist.

3. Verfahren nach Anspruch 1, worin die Kohlenstoff-Ionen oder -Atome auf oder in der Oberfläche des Substrats durch physikalische Abscheidung aus der Dampfphase, chemische Abscheidung aus der Dampfphase, Zerstäuben, Spalten, Ionenimplantation oder durch Plasma induzierte chemische Abscheidung aus der Dampfphase abgeschieden werden.

4. Verfahren nach irgendeinem der Ansprüche 1 bis 3, worin das Substrat ein kristallines Substrat ist.

5. Verfahren nach Anspruch 4, worin das kristalline Substrat Germanium, Silicium, Galliumarsenid, Indiumantimonid oder Molybdän ist.

6. Verfahren nach Anspruch 4, worin das kristalline Substrat Diamant ist.

7. Verfahren nach Anspruch 6, worin das Kristallwachstum des Diamants epitaxial, polykristallin oder als Einkristall erfolgt.

8. Verfahren nach irgendeinem der vorhergehenden Ansprüche, worin ein Atom einer Dotierungssubstanz in das gezüchtete kristalline Diamant-Material eingeführt wird.

## Revendications

1. Procédé pour obtenir la croissance cristalline du diamant sur un substrat, qui comprend le dépôt d'ions ou atomes de carbone sur ou dans la surface d'un substrat et l'irradiation simultanée du carbone déposé à l'aide d'un faisceau laser ayant une longueur d'onde choisie de façon à obtenir l'absorption de résonance par excitation des vibrations de réseau caractéristiques dans le carbone déposé.

2. Procédé suivant la revendication 1, dans lequel le faisceau laser est un laser à onde continue ou pulsé convenant pour l'absorption de résonance.

3. Procédé suivant la revendication 1 ou 2, dans lequel les ions ou atomes de carbone sont déposés sur ou dans la surface du substrat par dépôt physique à partir de la phase vapeur, dépôt chimique à partir de la phase vapeur, pulvérisation, craquage, implantation d'ions ou dépôt chimique à partir de la phase vapeur induit par un plasma.

4. Procédé suivant l'une quelconque des revendications 1 à 3, dans lequel le substrat est un substrat cristallin.

5. Procédé suivant la revendication 4, dans lequel le substrat cristallin est en germanium, en silicium, en arséniure de gallium, en antimoniure d'indium ou en molybdène.

6. Procédé suivant la revendication 4, dans lequel le substrat cristallin est en diamant.

7. Procédé suivant la revendication 6, dans lequel la croissance cristalline du diamant est épitaxiale, polycristalline ou monocristalline.

8. Procédé suivant l'une quelconque des revendications précédentes, dans lequel un atome dopant est introduit dans le diamant cristallin qui a crû.